# FASCICULE DE BREVET EUROPEEN

(11) **EP 3 029 477 B1**
(45) Date de publication et mention de la délivrance du brevet: **11.12.2019**
(21) Numéro de dépôt: 15187510.1
(22) Date de dépôt: 30.09.2015
(51) Int. Cl.: G01R 31/327, H02H 3/04, H02H 3/33, H02H 7/22, G01R 19/25, G01R 19/15

(54) **DISPOSITIF ET PROCÉDÉ DE SURVEILLANCE DE L'ÉTAT D'UN CIRCUIT DE PROTECTION OU D'ALIMENTATION ÉLECTRIQUE DANS UN RÉSEAU OU CIRCUIT DE DISTRIBUTION D'ÉNERGIE ÉLECTRIQUE, ET RÉSEAU ET CIRCUIT DE DISTRIBUTION CORRESPONDANTS**
VORRICHTUNG UND VERFAHREN ZUR ZUSTANDSÜBERWACHUNG EINES SCHUTZ- ODER VERSORGUNGSSCHALTKREISES IN EINEM NETZ ODER EINEM STROMVERTEILUNGSSCHALTKREIS, UND ENTSPRECHENDES VERTEILUNGSNETZ UND ENTSPRECHENDER VERTEILUNGSSCHALTKREIS
DEVICE AND METHOD FOR MONITORING THE STATE OF A PROTECTION OR POWER SUPPLY CIRCUIT IN AN ELECTRIC POWER DISTRIBUTION CIRCUIT OR NETWORK, AND CORRESPONDING DISTRIBUTION NETWORK AND CIRCUIT

(30) Priorité: 01.10.2014 FR 1459368
(43) Date de publication de la demande: 08.06.2016
(73) Titulaire: Schneider Electric Industries SAS, 92500 Rueil-Malmaison (FR)
(72) Inventeur: HOUBRE, Pascal, 38050 GRENOBLE Cedex 09 (FR); CONTINI, Erick, 38050 GRENOBLE Cedex 09 (FR); CLEMENCE, Michel, 38050 GRENOBLE Cedex 09 (FR)
(74) Mandataire: Lavoix

(56) Documents cités:
- EP-A1- 0 936 716
- EP-A1- 1 764 891
- EP-A1- 2 472 690
- EP-A1- 2 503 575
- EP-A2- 2 592 390
- WO-A1-2005/027295
- DE-A1- 4 104 184
- FR-A1- 2 873 510
- US-A1- 2006 221 521
- US-A1- 2010 302 700

## Description

La présente invention concerne un dispositif et un procédé de surveillance de l'état d'un circuit électrique alimenté en énergie électrique par une source d'énergie électrique, tel qu'un circuit de protection contre les surcharges électriques en sortie d'une source d'énergie électrique dans un réseau de distribution d'énergie électrique, ou tel qu'un circuit électrique d'alimentation d'un appareil électronique en sortie de la source d'énergie électrique dans un circuit de distribution d'énergie électrique. L'invention concerne également un tel réseau et un tel circuit de distribution d'énergie électrique.

Elle trouve notamment une application à la surveillance des dispositifs de protection disposés en sortie d'un transformateur Moyenne Tension (MT) / Basse Tension (BT) destiné à la distribution de l'énergie électrique sur tout ou partie du réseau.

Elle trouve également une application à la surveillance des dispositifs de mise en veille équipant les appareils électroniques, tels que les appareils électroniques domestiques.

Un réseau de distribution d'énergie électrique, ou distribution électrique, dans des quartiers d'habitation comporte en général un transformateur MT / BT qui délivre plusieurs sorties basse tension (230 V entre une phase et le neutre et 380 V entre deux phases). Ces sorties sont généralement protégées simplement par des fusibles au niveau du transformateur. Des disjoncteurs de protection sont installés en aval sur chaque ramification du réseau électrique, pour protéger ces ramifications.

Les fusibles disposés en sortie du transformateur sont peu sollicités, mais peuvent néanmoins fondre sous l'effet d'une surcharge importante qui ne serait pas éliminée par un des disjoncteurs installés en aval.

Aussi, il est utile pour le distributeur d'énergie d'être informé de la fonte du fusible dès que possible. Dans ce but, on peut équiper chaque sortie (ou départ) du transformateur d'un système de détection de fonte de fusible, tel que décrit par exemple dans WO 2005/027295.

Cependant, l'événement est rare, et il n'est donc économiquement pas intéressant d'équiper chaque départ d'un tel système de détection de fonte du fusible.

Il existe des solutions simples, donc moins couteuses, de surveillance de fusibles par mesure de tension, tel que celle décrite dans DE 4104184. Néanmoins, de telles solutions ne fonctionnent que dans le cas d'une distribution monophasée et ne peuvent être utilisées dans le cas plus général de la distribution triphasée.

On sait par ailleurs que les distributeurs d'énergie équipent généralement les différents départs de systèmes de mesure de l'énergie dans le but d'optimiser la gestion du réseau électrique. De tels système permettent notamment de réaliser des diagnostics, d'optimiser la charge, de réaliser un délestage, de détecter le vol d'énergie, etc...

Le document US 2006/221521 A1 décrit un disjoncteur comprenant des moyens de détection d'un niveau de courant. Le document FR 2 873 510 A1 décrit un système de sauvegarde d'un circuit de protection comprenant un capteur de courant. Il est connu du document EP 2 503 575 A1 un procédé de diagnostic d'un actionneur, comprenant une étape de surveillance d'une caractéristique électrique d'un signal électrique. Le document US 2010/302700 A1 décrit un dispositif de commutation électrique comprenant des capteurs de courant. Le document EP 0 936 716 A1 décrit un dispositif de protection différentielle comportant un tore pour mesurer des courants différentiels. Le document EP 1 764 891 A1 décrit un déclencheur électronique comportant des moyens de mesure du courant. Il est connu du document EP 2 472 690 un système de protection comportant un dispositif de mesure de courant.

Certains de ces systèmes permettent aussi d'informer sur l'état du réseau, pour permettre de déterminer par exemple si une protection a coupé une partie du réseau électrique, et dans ce cas, pour permettre de localiser le défaut.

Cependant, ces systèmes ne permettent pas toujours de mesure de la tension, car une telle mesure engendre des contraintes d'installation et un surcoût important. En effet, il faut dans ce cas que ces systèmes respectent les distances d'isolement et résistent aux surtensions du réseau en cas de foudre par exemple. Aussi, on utilise habituellement la mesure du courant associée à des algorithmes permettant d'en déduire l'état du réseau.

Un tel algorithme, qui peut être plus ou moins sophistiqué pour tenir compte ou pas du niveau de la surcharge, peut être du type : surcharge pendant un temps t supérieur à un temps tmax, puis courant = 0 A, implique une forte probabilité d'avoir une protection qui a interrompu le circuit électrique.

Dans de nombreux dispositifs de protection et de mesure du courant, l'alimentation de l'électronique est effectuée avec un ou plusieurs capteurs de courant, donc des capteurs d'alimentation de type fer. Ce type d'alimentation est appelé alimentation a propre courant.

La mesure est, quant à elle, effectuée par un autre capteur, préférentiellement, un capteur de type Rogowski, donc un capteur de mesure par phase de type air.

A titre d'exemple, on trouve un tel dispositif décrit dans FR 2 982 665.

Le problème principal de ce type de dispositifs, est la difficulté d'avoir la certitude qu'aucun courant ne traverse la phase mesurée.

En effet, le capteur de mesure utilisé, de type Rogowski, présente comme inconvénient de délivrer une tension si un conducteur parcouru par un courant est à proximité. Cela peut, suivant le calibre du dispositif, représenter un courant de l'ordre de 0,1 a plusieurs ampères. Ce phénomène est appelé diaphonie.

Or, dans le cas de la distribution électrique de type triphasée, les dispositifs qui équipent les circuits protégés par des fusibles, mesurent trois phases. Une phase peut alors être absente dans un conducteur, à la suite d'une surcharge ou d'un court-circuit, mais le capteur de mesure détectera quand même un courant en raison de l'alimentation par les capteurs des autres phases. Autrement dit, on ne fera pas la différence entre une phase manquante et une charge faible.

Pour éviter cela, on pourrait supprimer le phénomène de diaphonie en utilisant des capteurs composés d'un circuit magnétique. Cependant, de tels capteurs sont plus chers et encombrants, et présentent une dynamique réduite.

Ainsi, dans les dispositifs classiques utilisant un capteur de type Rogowski, il n'est pas possible de savoir avec certitude si le courant du conducteur mesuré est bien nul.

A l'inverse, pour les mêmes raisons que celles évoqués ci-dessus dans le cadre d'une application à la surveillance des dispositifs de protection disposés en sortie d'un transformateur MT / BT destiné à la distribution de l'énergie électrique sur tout ou partie du réseau, les dispositifs classiques de mise en veille équipant les appareils électroniques domestiques peuvent parfois ne pas détecter correctement la présence de courant qui devrait conduire à la ré-alimentation de l'appareil concerné.

Un des buts de l'invention est donc de résoudre les problèmes précités. Ainsi, l'invention a notamment pour objectif de proposer un dispositif et un procédé de distribution d'énergie électrique qui permettent de détecter l'absence de courant dans les dispositifs de protection par coupure des différents départs d'alimentation, en particulier dans le cas d'une distribution triphasée, sans équiper ces différents départs de dispositifs détection spécifiques couteux, ou qui permettre de détecter de façon fiable la présence de courant dans les dispositifs d'alimentation d'appareils électronique pour réactiver ces appareils après une mise en veille
Ainsi, l'invention a pour objet, selon un premier aspect, un dispositif de surveillance selon la revendication 1.

Suivant certains modes de réalisation, le dispositif est selon l'une quelconque des revendications 2 à 8.

L'invention a également pour objet, selon un deuxième aspect, un réseau de distribution d'énergie électrique selon la revendication 9.

Dans un mode de réalisation particulier, le réseau de distribution d'énergie électrique est selon la revendication 10.

L'invention a encore pour objet, selon un troisième aspect, un circuit de distribution d'énergie électrique selon la revendication 11.

L'invention a encore pour objet, selon un quatrième aspect, un procédé selon la revendication 12.

Suivant certains modes de mise en œuvre, le procédé est selon l'une quelconque des revendications 13 à 18.

Ainsi, l'utilisation du capteur ou circuit d'alimentation du dispositif de mesure, situé au niveau de chaque départ d'alimentation vers les ramifications du réseau, donc d'un circuit fer qui ne présente aucune sensibilité a la diaphonie, permet de détecter l'absence de courant dans la protection par fusible du départ en question en faisant clairement la différence entre une phase manquante et une charge très faible.

Egalement, l'utilisation de ce capteur ou circuit d'alimentation du dispositif de mesure, situé au niveau du circuit d'alimentation d'un appareil électronique, permet de détecter la présence de courant pour la ré-alimentation de l'appareil après une mise en veille, ou pour la non mise en veille de l'appareil, ou l'absence de courant pour la mise en veille, en faisant ici encore clairement la différence entre une phase manquante et une charge très faible.

L'invention permet donc d'assurer le diagnostic des fusibles des dispositifs de protection de chaque départ, en utilisant les ressources du système de mesure de puissance/énergie électrique installé sur chaque ramification du réseau de distribution d'énergie électrique, ou la mise en oeuvre fiable d'une fonction de mise en veille d'un appareil électronique.

Les caractéristiques et avantages de l'invention apparaitront à la lecture de la description qui va suivre, donnée uniquement à titre d'exemple, et non limitative, en référence aux figures annexées suivantes :
- figure 1 : représentation schématiquement un exemple de réseau de distribution d'énergie électrique selon l'invention ;
- figure 2 : représentation schématiquement d'une partie d'un premier exemple de dispositif de surveillance selon l'invention destiné à équiper un réseau tel que celui de la figure 1 au niveau de chaque départ vers les ramifications de ce réseau ;
- figure 3 : représentation schématiquement d'une partie d'un deuxième exemple de dispositif de surveillance selon l'invention destiné à équiper un réseau tel que celui de la figure 1 au niveau de chaque départ vers les ramifications de ce réseau ;
- figure 4 : représentation schématique d'une partie d'un troisième exemple de dispositif de surveillance selon l'invention destiné à équiper un circuit électronique avec fonction de mise en veille ;
- figures 5 à 7 : montrent différentes mesures effectuées sur un dispositif tel que celui représenté partiellement à la figure 2, respectivement dans les cas de faible courant primaire, de courant primaire relativement important, et d'absence de courant primaire, dans le circuit de protection surveillé.

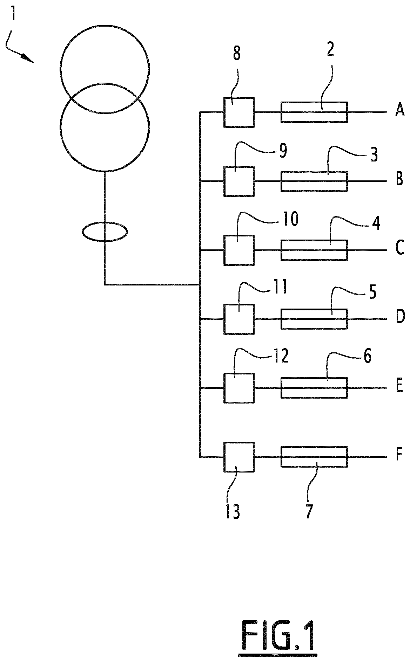

Sur la figure 1, on a représenté schématiquement un exemple de réseau de distribution d'énergie électrique selon l'invention, avec une source d'alimentation en énergie électrique 1 matérialisée par un transformateur 1 tel qu'un transformateur MT/BT.

Dans notre exemple, le réseau est triphasé, et permet de distribuer l'énergie électrique vers plusieurs ramifications A à F du réseau, qui peuvent correspondre par exemple aux différents quartiers d'une ville.

Chacune des sorties du transformateur 1 correspond à un départ vers une des ramifications A à F, et est équipée d'une part d'un circuit de protection contre les surcharges électriques et d'un dispositif de surveillance du circuit de protection selon l'invention qui comprend des moyens de mesure de l'énergie électrique distribuée en sortie vers la ramification correspondante.

Ainsi, les sorties vers les ramifications A à F sont équipées respectivement des circuits de protection 2 à 7, et respectivement également des dispositifs de surveillance comprenant les moyens de mesure 8 à 13.

Chaque circuit de protection 2 à 7 comprend au moins un fusible 2 à 7 et est assimilé à ce fusible sur la figure 1.

Le dispositif de surveillance comprenant le moyen de mesure 8 du circuit de protection 2, au niveau du départ vers la ramification A du réseau, permet de vérifier l'état de ce circuit de protection 2, et en particulier l'absence de courant dans ce circuit de protection 2, qui serait par exemple liée à la fonte du fusible 2 par suite d'une surcharge électrique.

Le principe est identique pour les autres dispositifs de surveillance comprenant respectivement les moyens de mesure 9 à 13 associés respectivement aux autres circuits de protection 3 à 7 au niveau des départs respectifs vers les autres ramifications B à F du réseau.

Les moyens de mesure 8 à 13 comprennent chacun un circuit capteur de mesure, ou circuit de mesure, de préférence de type Rogowski, permettant de mesurer l'énergie électrique distribuée vers la ramification A à F correspondante, et un circuit capteur d'alimentation, ou circuit d'alimentation, permettant de générer un courant électrique d'alimentation en fonction de l'énergie électrique mesurée par le circuit de mesure.

Un circuit d'alimentation débite un courant secondaire lorsqu'il est capable de fournir une tension supérieure à la tension d'alimentation. Mais la simple mesure du courant secondaire fourni par un circuit d'alimentation n'est pas suffisante, car en cas de faible charge du réseau, ce circuit d'alimentation ne débite aucun courant. Aussi, on s'intéresse à la tension aux bornes du circuit, pour être sûr de pouvoir déterminer si le courant primaire est nul ou non.

Ces considérations sur la figure 1 concernent également l'application à la mise en veille d'appareils électroniques, par exemple dans un circuit électrique domestique de distribution d'énergie qui est alimenté par une source d'alimentation en énergie électrique 1.

Chaque branche A à F du circuit de distribution d'énergie correspond à une branche de distribution vers un ou plusieurs appareils électroniques, avec des circuits électriques 2 à 7 d'alimentation et des moyens de mesure 8 à 13 au départ de charcune des branches A à F.

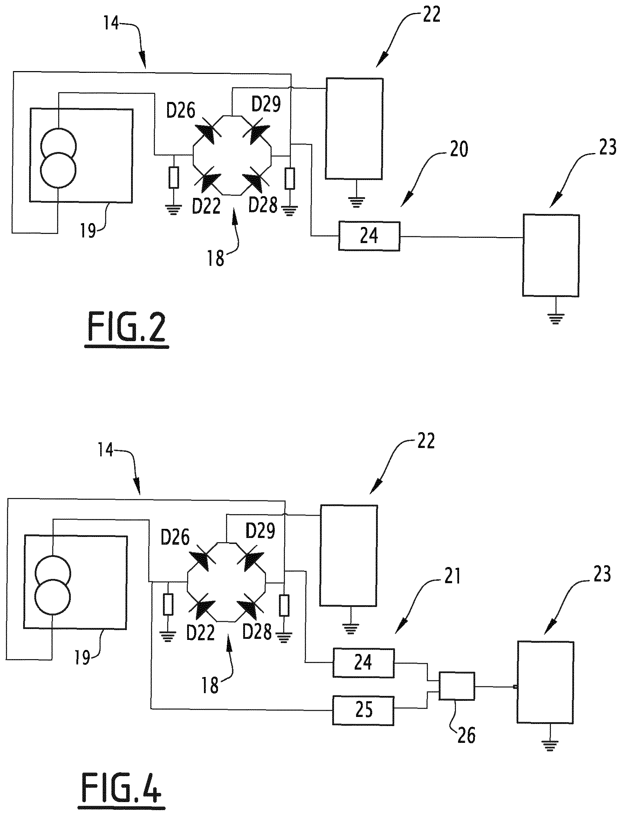

Un moyen de mesure 8 à 13 selon l'invention comprend donc un circuit d'alimentation particulier, tel que le circuit d'alimentation 14 qui va être décrit plus précisément en référence aux la figures 2 à 4.

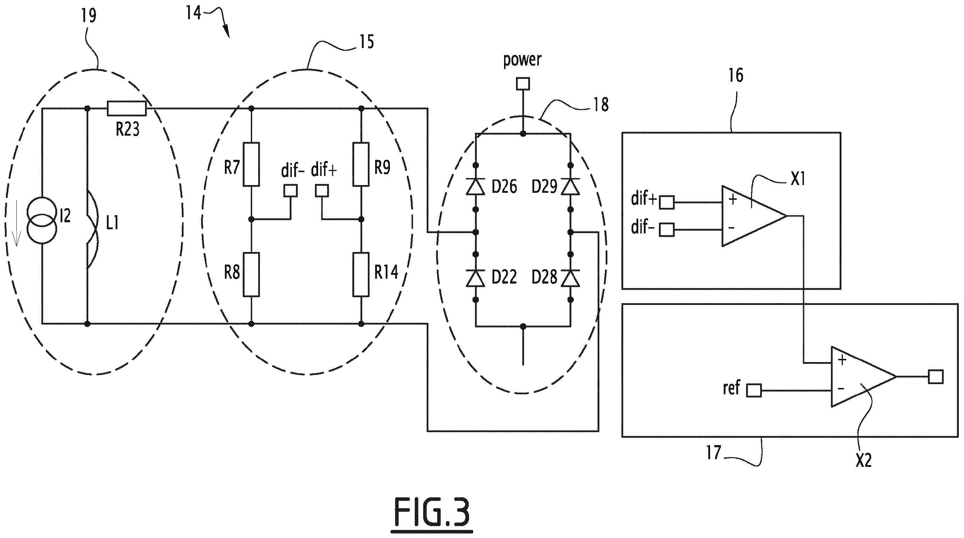

De manière classique, ce circuit d'alimentation 14 comprend des moyens d'alimentation 19, représentés dans l'exemple de la figure 3 par un transformateur I2 et une self magnétisante L1 en parallèle, et la résistance R23.

Il comprend également des moyens de redressements 18, tel qu'un pont de diodes 18 ou pont de Graetz 18 formé des quatre diodes D22, D26, D28, D29.

Ces moyens de redressements 18 permettent de redresser le courant débité par le les moyens d'alimentation 19 du circuit d'alimentation 14.

La sortie de ces moyens de redressement, repérée par l'étiquette « power » sur la figure 3, et reliée à une source de courant 22 sur les figures 2 et 4, permet de charger une capacité C1 non représentée sur les figures.

Entre les moyens d'alimentation 19 et les moyens de redressement 18, sont disposés des moyens de détection, référencés 15, 16, 17 sur la figure 3 et 20, 21 sur les figures 2 et 4.

Dans les exemples des figures 2 et 3, ces moyens de détection 15, 16, 17 ou 20 permettent de détecter l'absence de courant dans le circuit de protection correspondant, c'est-à-dire l'un des circuits de protection 2 à 7 de la figure 1 situé au niveau du départ de la source d'énergie électrique 1 vers l'une des ramifications A à F du réseau, et associé à l'un des dispositifs de mesure 8 à 13.

Dans l'exemple de la figure 4, ces moyens de détection 21 permettent de détecter la présence ou l'absence de courant dans le circuit électrique d'alimentation correspondant, c'est-à-dire l'un des circuits 2 à 7 de la figure 1 situé au niveau du départ de la source d'énergie électrique 1 vers l'une des ramifications A à F du circuit de distribution, et associé à l'un des dispositifs de mesure 8 à 13.

Cette détection est ainsi obtenue par la mesure de la tension aux bornes du circuit d'alimentation 14.

Dans l'exemple de la figure 2, les moyens de détection 20 comprennent au moins un moyen de comparaison 24.

La fonction de ce moyen de comparaison 24 est de comparer une valeur de tension en entrée par rapport à une valeur de tension de référence et de délivrer en sortie une tension quand l'écart entre cette tension d'entrée et la tension de référence est positif.

Précisément, le moyen de comparaison 24 mesure la différence entre d'une part la tension entre l'une des bornes des moyens d'alimentation 19 et l'une des bornes des moyens de redressement 18, et d'autre part une tension de référence, et délivre en sortie une tension quand cette différence est positive, donc lorsqu'il y a du courant dans l'une des phases surveillées par le dispositif.

A l'inverse, lorsque l'on n'obtient pas de tension en sortie du moyen de comparaison 24, du fait d'une différence inférieure ou égale à zéro entre d'une part la tension entre l'une des bornes des moyens d'alimentation 19 et l'une des bornes des moyens de redressement 18, et d'autre part une tension de référence, on en déduit l'absence de courant dans la phase surveillée par le dispositif.

L'information obtenue par les moyens de détection 20 est alors transmise à des moyens de calcul 23 pour traitement et utilisation.

Dans l'exemple de la figure 3, les moyens de détection 15, 16, 17 comprennent deux ponts de résistance 15, ainsi qu'un moyen d'amplification différentielle 16, placés entre les moyens d'alimentation 19 et les moyens de redressement 18.

Le moyen d'amplification différentielle 16 comprend notamment un amplificateur X1.

Les deux ponts de résistance 15 sont reliés au moyen d'amplification différentielle 16 en sorte de permettre l'amplification de la différence entre la tension en l'un et l'autre des deux ponts 15.

Ainsi, si le premier pont comprend les deux résistances R7, R8 et le deuxième pont comprend les deux résistances R9, R14, le moyen d'amplification différentielle 16 permet l'amplification de la différence entre la tension en le premier pont R7, R8 et la tension en le deuxième pont R9, R14, d'une part par une liaison entre un point de liaison dif- entre les deux résistances R7, R8 du premier des deux ponts 15 et l'une dif- des deux entrées dif-, dif+ du moyen d'amplification différentielle 16, et d'autre part par une liaison entre un point de liaison dif+ entre les deux résistances R9, R14 du deuxième des deux ponts 15 et l'autre dif+ des deux entrées dif-, dif+ du moyen d'amplification différentielle 16.

Les moyens de détection 15, 16, 17 comprennent également un moyen de comparaison 17 dont la fonction est de comparer une valeur de tension en entrée par rapport à une valeur de tension de référence et de délivrer en sortie une tension quand l'écart entre cette tension d'entrée et la tension de référence est positif.

Le moyen de comparaison 17 comprend notamment un comparateur X2.

Ainsi, la tension de sortie U_{X1} du moyen d'amplification différentielle 16 est injectée en entrée du moyen de comparaison 17, ce qui permet à ce moyen de comparaison 17 de délivrer en sortie une tension U_{X2} quand l'écart entre la tension de sortie U_{X1} du moyen d'amplification différentielle 16 et la tension de référence est positif.

Plus précisément, la comparaison par le moyen de comparaison 17 et par rapport à une valeur de référence, entre la différence U_{X1}, amplifiée par le moyen d'amplification différentielle 16, entre la tension en le premier R7, R8 des deux ponts de résistance 15 et la tension en le deuxième R9, R14 des deux ponts de résistance 15, permet d'obtenir une tension U_{X2} lorsque la différence en question est positive, donc lorsqu'il y a du courant dans l'une des phases surveillées par le dispositif.

A l'inverse, lorsque l'on n'obtient pas de tension U_{X2} en sortie du moyen de comparaison 17, du fait d'une différence inférieure ou égale à zéro entre la tension différentielle amplifiée U_{X1} et la valeur de référence, on en déduit l'absence de courant dans la phase surveillée par le dispositif.

L'information obtenue par les moyens de détection 15 à 17, est également transmise à des moyens de calcul, non représentés sur la figure 3, pour traitement et utilisation.

Dans l'exemple de la figure 4, les moyens de détection 21 comprennent deux moyens de comparaison 24, 25.

La fonction de ces deux moyens de comparaison 24, 25 est également de comparer une valeur de tension en entrée par rapport à une valeur de tension de référence et de délivrer en sortie une tension quand l'écart entre cette tension d'entrée et la tension de référence est positif.

Précisément, le premier moyen de comparaison 24 mesure la différence entre d'une part la tension entre une première des bornes des moyens d'alimentation 19 et une première des bornes des moyens de redressement 18, et d'autre part une tension de référence, et délivre en sortie une tension quand cette différence est positive.

Par ailleurs, le deuxième moyen de comparaison 25 mesure la différence entre d'une part la tension entre une deuxième des bornes des moyens d'alimentation 19 et une deuxième des bornes des moyens de redressement 18, et d'autre part une tension de référence, et délivre en sortie une tension quand cette différence est positive.

Dans cette variante, les moyens de détection 21 comprennent également un module logique 26, ou porte logique 26, à deux entrées, ajouté en sortie des deux moyens de comparaison 24, 25. Cette porte logique 26 délivre un signal en sortie lorsqu'elle reçoit un signal sur au moins l'une de ses deux entrées.

Ainsi, la porte logique 26 délivre une tension de sortie lorsqu'au moins un des deux moyens de comparaison 24, 25 délivre une tension de sortie.

L'information ainsi obtenue par les moyens de détection 21 est également transmise à des moyens de calcul 23 pour traitement et utilisation.

Il est par exemple possible de mettre en veille le circuit électronique correspondant, en fonction de la présence ou non d'une tension en sortie de la porte logique 26. En effet, si aucun des deux moyens de comparaison 24, 25 ne délivre une tension en sortie, cela signifie qu'il n'y a pas de consommation de courant ou une consommation de courant très faible, et que le circuit électronique correspondant peut être mis en veille.

De la sorte, on peut surveiller l'état du circuit de protection 2 à 7 correspondant en détectant l'absence de courant dans ce circuit de protection 2 à 7 par l'intermédiaire des moyens de détection 15 à 17 ou 20 décrits précédemment, en référence aux figures 2 et 3, qui sont insérés dans le circuit d'alimentation 14 d'un dispositif de mesure 8 à 13 de l'énergie électrique distribuée vers l'une des ramifications A à F du réseau.

Cette détection de l'absence de courant dans le circuit de protection 2 à 7 correspondant, est obtenue par la mesure de la tension aux bornes du circuit d'alimentation 14 par les moyens de détection 15 à 17.

Egalement, on peut surveiller l'état du circuit électrique 2 à 7 correspondant en détectant la présence de courant dans ce circuit 2 à 7 par l'intermédiaire des moyens de détection 21 décrits précédemment, en référence à la figure 4, qui sont insérés dans le circuit d'alimentation 14 d'un dispositif de mesure 8 à 13 de l'énergie électrique distribuée vers l'une des ramifications A à F du circuit de distribution.

Cette détection de la présence de courant dans le circuit d'alimentation 2 à 7 correspondant, est obtenue par la mesure de la tension aux bornes du circuit d'alimentation 14 par les moyens de détection 21.

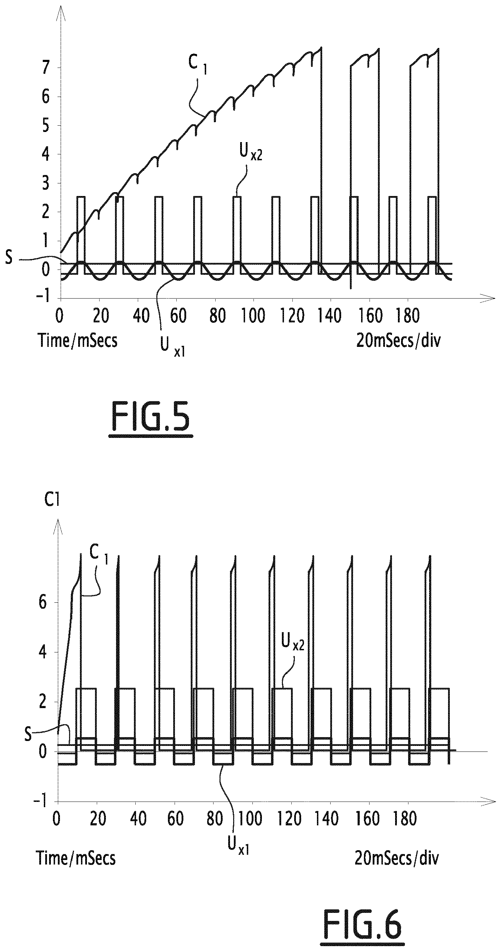

Les figures 5 à 7 montrent différentes mesures effectuées sur le dispositif de surveillance dans la variante de la figure 3, pour illustrer la détection de l'absence de courant primaire dans le circuit d'alimentation 14, donc dans le circuit de protection 2 à 7 surveillé.

Plus précisément, on s'intéresse à un dispositif de surveillance comprenant un dispositif de mesure 8 à 13 avec un capteur d'alimentation 14 selon l'invention, et un capteur d'alimentation classique.

Le cas de la figure 5 correspond au cas d'un faible courant primaire dans le circuit ou capteur d'alimentation 14, à savoir un courant primaire de 0.1 A, et un courant primaire de 10 A dans l'autre circuit ou capteur d'alimentation.

La courbe repérée par les étiquettes C1 montre la charge de la capacité C1 mentionnée plus haut (mais non représentée sur les figures).

La courbe sinusoïdale repérée par les étiquettes Uₓ₁ montre la tension à la sortie du moyen d'amplification différentielle 16.

La courbe repérée par l'étiquette S montre le seuil du comparateur utilisé dans le moyen de comparaison 17.

Enfin, la courbe repérée par les étiquettes Uₓ₂ montre la tension à la sortie du moyen du moyen de comparaison 17. Cette tension Uₓ₂ est non nulle, et traduit la présence du courant primaire de 0.1 A dans le circuit d'alimentation 14.

La figure 5 montre un cas limite de fonctionnement. On voit ainsi qu'il est possible de discriminer un courant primaire supérieur ou égal à 0.1 A d'un courant nul.

Le cas de la figure 6 correspond au cas d'un courant primaire relativement important dans le circuit ou capteur d'alimentation 14, à savoir un courant primaire de 600 A, et un courant primaire de 10 A dans l'autre circuit ou capteur d'alimentation.

Dans ce cas, le courant primaire dans le circuit d'alimentation 14 étant plus important que dans le cas de la figure 3, la charge de la capacité C1 est plus rapide comme le montre la courbe repérée par les étiquettes C1.

Par ailleurs, la tension de sortie Uₓ₁ du moyen d'amplification différentielle 16 est saturée, comme on peut le voir sur la courbe repérée par les étiquettes Uₓ₁.

La courbe repérée par l'étiquette S, correspondant au seuil du comparateur utilisé dans le moyen de comparaison 17, est inchangée par rapport au cas de la figure 3.

La courbe repérée par les étiquettes Uₓ₂ montre la tension à la sortie du moyen du moyen de comparaison 17. Cette tension Uₓ₂ est non nulle, et traduit la présence du courant primaire de 600 A dans le circuit d'alimentation 14.

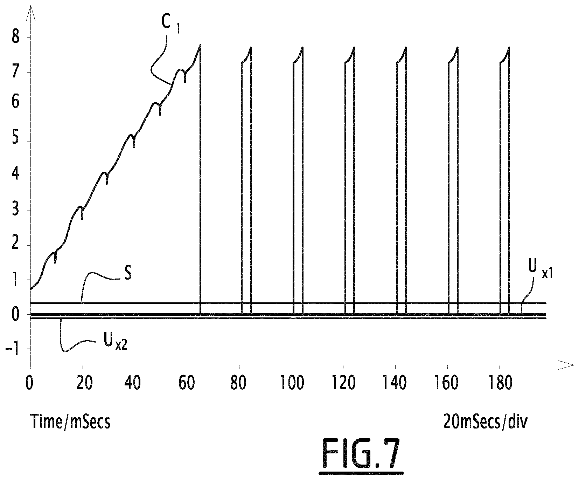

Le cas de la figure 7 correspond au cas de l'absence d'un courant primaire dans le circuit ou capteur d'alimentation 14 (courant primaire de 0 A), et un courant primaire de 10 A dans l'autre circuit ou capteur d'alimentation.

Dans ce cas, on observe qu'une charge de la capacité C1 a lieu en dépit de l'absence de courant primaire dans le circuit ou capteur d'alimentation 14, comme le montre la courbe repérée par les étiquettes C1, en raison du courant délivré par les autres capteurs d'alimentation.

Mais comme il n'y a pas de courant primaire, la tension de sortie Uₓ₁ du moyen d'amplification différentielle 16 et la tension de sortie Uₓ₂ du moyen de comparaison 17 sont nulles, comme on peut le voir sur les courbes repérées respectivement par les étiquettes Uₓ₁ et par les étiquettes Uₓ₂.

La courbe repérée par l'étiquette S correspond toujours au seuil du comparateur utilisé dans le moyen de comparaison 17, est reste donc inchangée par rapport aux cas des figures 5 et 6.

La présente description est donnée à titre d'exemple et n'est pas limitative de l'invention.

## Revendications

1. Dispositif de surveillance destiné à vérifier l'état d'un circuit électrique (2 à 7) alimenté en énergie électrique par une source d'énergie électrique (1), tel qu'un circuit électrique (2 à 7) de protection contre les surcharges électriques du type comportant au moins un fusible (2 à 7) et équipant une sortie de la source d'énergie électrique (1) dans un réseau de distribution électrique, ou tel qu'un circuit électrique (2 à 7) d'alimentation d'un appareil électronique en sortie de la source d'énergie électrique (1), ledit dispositif de surveillance comprenant des moyens de mesure (8 à 13) d'au moins une grandeur électrique, telle que l'énergie électrique, associée au circuit électrique (2 à 7) alimenté par la source d'énergie électrique (1), lesdits moyens de mesure (8 à 13) comportant au moins un circuit d'alimentation (14) apte à générer un courant électrique d'alimentation et au moins un circuit de mesure, par exemple de type Rogowski, apte à mesurer ladite grandeur électrique associée audit circuit d'alimentation (14),
**caractérisé en ce que** le circuit d'alimentation (14) comprend des moyens de détection (15 à 17, 20, 21) aptes à détecter l'absence ou la présence de courant dans le circuit électrique (2 à 7) par mesure de la tension aux bornes du circuit d'alimentation (14).

2. Dispositif selon la revendication 1, **caractérisé en ce que** le circuit d'alimentation (14) comprend des moyens d'alimentation (19) et des moyens de redressement (18), tels qu'un pont de Graetz (18), aptes à redresser le courant délivré par les moyens d'alimentation (19), et **en ce que** les moyens de détection (15 à 17, 20, 21) sont disposés entre les moyens d'alimentation (19) et les moyens de redressement (18).

3. Dispositif selon la revendication 2, **caractérisé en ce que** les moyens de détection (15 à 17) comprennent deux ponts de résistance (15) en parallèle entre les moyens d'alimentation (19) et les moyens de redressement (18), et un moyen d'amplification différentielle (16), et **en ce que** les deux ponts de résistance (15) sont reliés au moyen d'amplification différentielle (16) en sorte de permettre l'amplification de la différence entre la tension en l'un (R7, R8) des deux ponts de résistances (15) et la tension en l'autre (R9, R14) de ces deux ponts de résistance (15).

4. Dispositif selon la revendication 3, **caractérisé en ce que** chacun des deux ponts de résistance (15) comprend deux résistances (R7, R8, R9, R14), et est relié à une des deux entrées (dif-, dif+) du moyen d'amplification différentielle (16) par un point de liaison (dif-, dif+) situé entre lesdites deux résistances (R7, R8, R9, R14).

5. Dispositif selon l'une quelconque des revendications 3 et 4, **caractérisé en ce que** les moyens de détection (15 à 17) comprennent un moyen de comparaison (17) apte à comparer une valeur de tension en entrée par rapport à une valeur de tension de référence et à délivrer en sortie une tension quand l'écart entre cette tension d'entrée et la tension de référence est positif, et **en ce que** la tension de sortie du moyen d'amplification différentielle (16) est reliée à l'entrée du moyen de comparaison (17), en sorte que le moyen de comparaison (17) délivre en sortie une tension quand l'écart entre la tension de sortie du moyen d'amplification différentielle (16) et la tension de référence est positif.

6. Dispositif selon la revendication 2, **caractérisé en ce que** les moyens de détection (20) comprennent au moins un moyen de comparaison (24) apte à comparer une valeur de tension en entrée par rapport à une valeur de tension de référence et à délivrer en sortie une tension quand l'écart entre cette tension d'entrée et la tension de référence est positif, et **en ce que** la tension entre l'une des bornes des moyens d'alimentation (19) et l'une des bornes des moyens de redressement (18) est reliée à l'entrée du moyen de comparaison (24), en sorte que le moyen de comparaison (24) délivre en sortie une tension quand l'écart entre la tension entre ladite borne des moyens d'alimentation (19) et ladite borne des moyens de redressement (18) et la tension de référence est positif.

7. Dispositif selon la revendication 2, **caractérisé en ce que** les moyens de détection (21) comprennent au moins deux moyens de comparaison (24, 25) chacun apte à comparer une valeur de tension en entrée par rapport à une valeur de tension de référence et à délivrer en sortie une tension quand l'écart entre cette tension d'entrée et la tension de référence est positif, **en ce que** la tension entre une première des bornes des moyens d'alimentation (19) et une première des bornes des moyens de redressement (18) est reliée à l'entrée d'un premier (24) des moyens de comparaison (24, 25), et **en ce que** la tension entre une deuxième des bornes des moyens d'alimentation (19) et une deuxième des bornes des moyens de redressement (18) est reliée à l'entrée d'un deuxième (25) des moyens de comparaison (24, 25), en sorte que les premier et deuxième moyens de comparaison (24, 25) délivrent respectivement en sortie une tension quand l'écart entre la tension entre la première respectivement la deuxième des bornes des moyens d'alimentation (19) et la première respectivement la deuxième des bornes des moyens de redressement (18) et la tension de référence est positif.

8. Dispositif selon la revendication 7, **caractérisé en ce que** les moyens de détection (21) comprennent une porte logique (26) à deux entrées reliées respectivement aux tensions de sortie des deux moyens de comparaison (24, 25), et apte délivrer une tension de sortie lorsque au moins l'un des deux moyens de comparaison (24, 25) délivre une tension de sortie.

9. Réseau de distribution d'énergie électrique comprenant plusieurs ramifications (A à F) et une source d'énergie électrique (1) apte à délivrer en sortie de l'énergie électrique pour chaque ramification (A à F), au moins une des sorties de la source d'énergie électrique (1) étant équipée d'un circuit électrique (2 à 7) de protection contre les surcharges électriques du type comportant au moins un fusible (2 à 7),
**caractérisé en ce qu'**il comprend, pour au moins ladite sortie de la source d'énergie électrique (1), un dispositif de surveillance selon l'une quelconque des revendications 1 à 6, en sorte de permettre la détection de l'absence de courant dans le circuit électrique (2 à 7) de protection de ladite sortie de la source d'énergie électrique (1).

10. Réseau de distribution selon la revendication 9, **caractérisé en ce que** la source d'énergie électrique (1) est apte à délivrer en sortie de l'énergie électrique triphasée pour au moins l'une des ramifications (A à F) du réseau de distribution.

11. Circuit de distribution d'énergie électrique dans un appareil électronique, comprenant un circuit électrique (2 à 7) d'alimentation et une source d'énergie électrique (1) apte à délivrer en sortie de l'énergie électrique au circuit électrique (2 à,7) d'alimentation,
**caractérisé en ce qu'**il comprend un dispositif de surveillance selon l'une quelconque des revendications 1,2, 7 et 8, en sorte de permettre la détection de la présence de courant dans le circuit électrique (2 à 7) d'alimentation.

12. Procédé de surveillance de l'état d'un circuit électrique (2 à 7) alimenté en énergie électrique par une source d'énergie électrique (1), tel qu'un circuit électrique (2 à 7) de protection contre les surcharges électriques du type comportant au moins un fusible (2 à 7) et équipant une sortie de la source d'énergie électrique (1) dans un réseau de distribution d'énergie électrique, ou tel qu'un circuit électrique (2 à 7) d'alimentation d'un appareil électronique en sortie de la source d'énergie électrique (1), au moyen d'un dispositif de surveillance comprenant des moyens de mesure (8 à 13) d'au moins une grandeur électrique, telle que l'énergie électrique, associée au circuit électrique (2 à 7), lesdits moyens de mesure (8 à 13) comportant au moins un circuit d'alimentation (14) apte à générer un courant électrique d'alimentation et au moins un circuit de mesure, par exemple de type Rogowski, apte à mesurer ladite grandeur électrique associée audit circuit d'alimentation (14),
**caractérisé en ce qu'**il comprend une étape de détection de l'absence ou de la présence de courant dans le circuit électrique (2 à 7) par la mesure de la tension aux bornes du circuit d'alimentation (14) par des moyens de détection (15 à 17, 20, 21).

13. Procédé selon la revendication 12, le circuit d'alimentation (14) comprenant deux ponts de résistance (15) disposés entre des moyens d'alimentation (19) et des moyens de redressement (18), tels qu'un pont de Graetz (18), **caractérisé en ce que** la mesure de la tension aux bornes du circuit d'alimentation (14) comprend l'amplification, par un moyen d'amplification différentielle (16), de la différence entre la tension en l'un (R7, R8) des deux ponts (15) et la tension en l'autre (R9, R14) des deux ponts (15).

14. Procédé selon la revendication 13, **caractérisé en ce que** la mesure de la tension aux bornes du circuit d'alimentation (14) comprend la comparaison, par un moyen de comparaison (17), de la tension différentielle amplifiée par le moyen d'amplification différentielle (16) par rapport à une valeur de référence, et la fourniture d'une tension de sortie par le moyen de comparaison (17) quand la tension différentielle amplifiée en entrée est supérieure à la tension de référence.

15. Procédé selon la revendication 12, le circuit d'alimentation (14) comprenant des moyens d'alimentation (19) et des moyens de redressement (18), tels qu'un pont de Graetz (18), **caractérisé en ce que** la mesure de la tension aux bornes du circuit d'alimentation (14) comprend la comparaison, par un moyen de comparaison (24), de la valeur de tension entre l'une des bornes des moyens d'alimentation (19) et l'une des bornes des moyens de redressement (18), et la fourniture d'une tension de sortie par le moyen de comparaison (24) quand l'écart entre la tension entre ladite borne des moyens d'alimentation (19) et ladite borne des moyens de redressement (18) et la tension de référence est positif.

16. Procédé selon la revendication 12, le circuit d'alimentation (14) comprenant des moyens d'alimentation (19) et des moyens de redressement (18), tels qu'un pont de Graetz (18), **caractérisé en ce que** la mesure de la tension aux bornes du circuit d'alimentation (14) comprend la comparaison, par un premier moyen de comparaison (24), de la valeur de tension entre une première des bornes des moyens d'alimentation (19) et une première des bornes des moyens de redressement (18), la comparaison, par un deuxième moyen de comparaison (25), de la valeur de tension entre une deuxième des bornes des moyens d'alimentation (19) et une deuxième des bornes des moyens de redressement (18), et la fourniture d'une tension de sortie respective par les premier et deuxième moyens de comparaison (24, 25) quand l'écart entre la tension entre la première respectivement la deuxième des bornes des moyens d'alimentation (19) et la première respectivement la deuxième des bornes des moyens de redressement (18) et la tension de référence est positif.

17. Procédé selon la revendication 16, **caractérisé en ce que** la mesure de la tension aux bornes du circuit d'alimentation (14) comprend la fourniture, par une porte logique (26) à deux entrées reliées respectivement aux tensions de sortie des deux moyens de comparaison (24, 25), d'une tension de sortie lorsque au moins l'un des deux moyens de comparaison (24, 25) délivre une tension de sortie.

18. Procédé selon la revendication 17, le circuit électrique (2 à 7) surveillé étant un circuit d'alimentation d'un appareil électronique, **caractérisé en ce qu'**il comprend la mise en veille de l'appareil électronique en fonction de l'absence de tension en sortie de la porte logique (26).

## Patentansprüche

1. Überwachungsvorrichtung zum Überprüfen des Zustandes eines elektrischen Schaltkreises (2 bis 7), der von einer elektrischen Energiequelle (1) mit elektrischer Energie versorgt wird, wie eines elektrischen Schaltkreises (2 bis 7) zum Schutz gegen elektrische Überlast, der Art, die mindestens eine Sicherung (2 bis 7) aufweist, und der einen Ausgang der elektrischen Energiequelle (1) in einem elektrischen Verteilernetz ausrüstet, oder wie eines elektrischen Schaltkreises (2 bis 7) zum Versorgen eines elektrischen Gerätes am Ausgang der elektrischen Energiequelle (1), wobei die Überwachungsvorrichtung Mittel (8 bis 13) zum Messen mindestens einer elektrischen Größe, wie der elektrischen Energie, die dem von der elektrischen Energiequelle (1) versorgten elektrischen Schaltkreis (2 bis 7) zugeordnet ist, umfasst, wobei die Messmittel (8 bis 13) mindestens einen Versorgungskreis (14), der geeignet ist, einen elektrischen Versorgungstrom zu erzeugen, und mindestens einen Messkreis, beispielsweise nach Art einer Rogowski-Schaltung, der geeignet ist, die dem Versorgungskreis (14) zugeordnete elektrische Größe zu messen, aufweisen,
**dadurch gekennzeichnet, dass** der Versorgungskreis (14) Detektionsmittel (15 bis 17, 20, 21) umfasst, die geeignet sind, durch Messung der Spannung an den Klemmen des Versorgungskreises (14) das Nichtvorhandensein oder das Vorhandensein des Stroms in dem elektrischen Schaltkreis (2 bis 7) zu detektieren.

2. Vorrichtung nach Anspruch 1, **dadurch gekennzeichnet, dass** der Versorgungskreis (14) Versorgungsmittel (19) und Gleichrichtermittel (18), wie eine Graetz-Brücke (18) umfasst, die geeignet sind, den von den Versorgungsmitteln (19) gelieferten Strom gleichzurichten, und dass die Detektionsmittel (15 bis 17, 20, 21) zwischen den Versorgungsmitteln (19) und den Gleichrichtermitteln (18) angeordnet sind.

3. Vorrichtung nach Anspruch 2, **dadurch gekennzeichnet, dass** die Detektionsmittel (15 bis 17) zwei parallel liegende Widerstandsbrücken (15) zwischen den Versorgungsmitteln (19) und den Gleichrichtermitteln (18) und ein Mittel (16) zur differentielle Verstärkung umfassen und dass die zwei Widerstandsbrücken (15) mit dem Mittel (16) zur differentiellen Verstärkung verbunden sind, um die Verstärkung der Differenz zwischen der Spannung der einen (R7, R8) der zwei Widerstandsbrücken (15) und die Spannung der anderen der zwei Widerstandsbrücken (15) zu verstärken.

4. Vorrichtung nach Anspruch 3, **dadurch gekennzeichnet, dass** jede der zwei Widerstandsbrücken (15) zwei Widerstände (R7, R8, R9, R14) umfasst und mit einem von zwei Eingängen (dif-, dif+) des Mittels (16) zur differentiellen Verstärkung über einen Verbindungspunkt (dif-, dif+) verbunden ist, der zwischen den zwei Widerständen (R7, R8, R9, R14) liegt.

5. Vorrichtung nach einem beliebigen der Ansprüche 3 und 4, **dadurch gekennzeichnet, dass** die Detektionsmittel (15 bis 17) mindestens ein Vergleichsmittel (17) umfassen, das geeignet ist, einen Spannungswert am Eingang mit einem Referenzspannungswert zu vergleichen und am Ausgang eine Spannung zu liefern, wenn der Unterschied zwischen dieser Eingangsspannung und der Referenzspannung positiv ist, und dass die Ausgangsspannung des Mittels (16) zur differentiellen Verstärkung an den Eingang des Vergleichsmittels (17) angeschlossen ist, derart dass das Vergleichsmittel (16) am Ausgang eine Spannung liefert, wenn der Unterschied der Ausgangsspannung des Mittels (16) zur differentiellen Verstärkung und der Referenzspannung positiv ist.

6. Vorrichtung nach Anspruch 2, **dadurch gekennzeichnet, dass** die Detektionsmittel (20) mindestens ein Vergleichsmittel (24) umfassen, das geeignet ist, einen Spannungswert am Eingang mit einem Referenzspannungswert zu vergleichen und am Ausgang eine Spannung zu liefern, wenn der Unterschied zwischen dieser Eingangsspannung und der Referenzspannung positiv ist, und dass die Spannung zwischen einer der Klemmen der Versorgungsmittel (19) und einer der Klemmen der Gleichrichtermittel (18) an den Eingang des Vergleichsmittels (24) angeschlossen ist, derart dass das Vergleichsmittel (24) am Ausgang eine Spannung liefert, wenn der Unterschied zwischen der Spannung zwischen der Klemme der Versorgungsmittel (19) und der Klemme der Gleichrichtermittel (18) und der Referenzspannung positiv ist.

7. Vorrichtung nach Anspruch 2, **dadurch gekennzeichnet, dass** die Detektionsmittel mindestens zwei Vergleichsmittel (24, 25) umfassen, wobei jedes geeignet ist, einen Spannungswert am Eingang mit einem Referenzspannungswert zu vergleichen und am Ausgang eine Spannung zu liefern, wenn der Unterschied zwischen dieser Eingangsspannung und der Referenzspannung positiv ist, dass die Spannung zwischen einer ersten der Klemmen der Versorgungsmittel (19) und einer ersten der Klemmen der Gleichrichtermittel (18) an den Eingang eines ersten (24) der Vergleichsmittel (24, 25) angeschlossen ist, und dass die Spannung zwischen einer zweiten der Klemmen der Versorgungsmittel (19) und einer zweiten der Klemmen der Gleichrichtermittel (18) an den Eingang eines zweiten (25) der Vergleichsmittel (24, 25) angeschlossen ist, derart dass das erste und zweite Vergleichsmittel (24, 25) jeweils am Ausgang eine Spannung liefern, wenn der Unterschied zwischen der Spannung zwischen der ersten bzw. zweiten der Klemmen der Versorgungsmittel (19) und der ersten bzw. zweiten der Klemmen der Gleichrichtermittel (18) und der Referenzspannung positiv ist.

8. Vorrichtung nach Anspruch 7, **dadurch gekennzeichnet, dass** die Detektionsmittel (21) ein logisches Gatter (26) mit zwei Eingängen umfassen, die jeweils an die Ausgangsspannungen der zwei Vergleichsmittel (24, 25) angeschlossen sind und geeignet sind, eine Ausgangsspannung zu liefern, wenn mindestens eines der zwei Vergleichsmittel (24, 25) eine Ausgangsspannung liefert.

9. Verteilernetz zur Verteilung von elektrischer Energie, das mehrere Verzweigungen (A bis F) und eine elektrische Energiequelle (1) umfasst, die geeignet ist, am Ausgang eine elektrische Energie für jede Verzweigung (A bis F) zu liefern, wobei mindestens einer der Ausgänge der elektrischen Energiequelle (1) mit einem elektrischen Schaltkreis (2 bis 7) zum Schutz gegen elektrische Überlast ausgerüstet ist, der Art, die mindestens eine Sicherung (2 bis 7) umfasst,
**dadurch gekennzeichnet, dass** es für mindestens den Ausgang der elektrischen Energiequelle (1) eine Überwachungsvorrichtung nach einem beliebigen der Ansprüche 1 bis 6 umfasst, um die Detektion des Nichtvorhandenseins eines Stroms in dem elektrischen Schaltkreis (2 bis 7) zum Schutz des Ausgangs der elektrischen Energiequelle (1) zu ermöglichen.

10. Verteilernetz nach Anspruch 9, **dadurch gekennzeichnet, dass** die elektrische Energiequelle (1) geeignet ist, am Ausgang eine elektrische Dreiphasenenergie für mindestens eine der Verzweigungen (A bis F) des Verteilernetzes zu liefern.

11. Schaltkreis zur Verteilung von elektrischer Energie in einem elektronischen Gerät, umfassend einen elektrischen Schaltkreis (2 bis 7) zur Versorgung und eine elektrische Energiequelle (1), die geeignet ist, am Ausgang eine elektrische Energie an den elektrischen Schaltkreis (2 bis 7) zur Versorgung zu liefern,
**dadurch gekennzeichnet, dass** er eine Überwachungsvorrichtung nach einem beliebigen der Ansprüche 1, 2, 7 und 8 umfasst, um die Detektion des Vorhandenseins eines Stroms in dem elektrischen Schaltkreis (2 bis 7) zur Versorgung zu ermöglichen.

12. Verfahren zur Überwachung des Zustandes eines elektrischen Schaltkreises (2 bis 7), der von einer elektrischen Energiequelle (1) mit elektrischer Energie versorgt wird, wie eines elektrischen Schaltkreises (2 bis 7) zum Schutz gegen elektrische Überlast, der Art, die mindestens eine Sicherung (2 bis 7) aufweist und einen Ausgang der elektrischen Energiequelle (1) in einem elektrischen Verteilernetz ausrüstet, oder wie eines elektrischen Schaltkreises (2 bis 7) der Versorgung eines elektrischen Gerätes am Ausgang der elektrischen Energiequelle (1), mittels einer Überwachungsvorrichtung, die Mittel (8 bis 13) zum Messen mindestens einer elektrischen Größe, wie der elektrischen Energie, die dem elektrischen Schaltkreis (2 bis 7) zugeordnet ist, umfasst, wobei die Messmittel (8 bis 13) mindestens einen Versorgungskreis (14), der geeignet ist, einen elektrischen Versorgungstrom zu erzeugen, und mindestens einen Messkreis, beispielsweise eine Rogowski Schaltung, aufweisen, der geeignet ist, die dem Versorgungskreis (14) zugeordnete elektrische Größe zu messen,
**dadurch gekennzeichnet, dass** es einen Schritt des Detektierens des Nichtvorhandenseins oder des Vorhandenseins des Stroms in dem elektrischen Schaltkreis (2 bis 7) durch Messung der Spannung an den Klemmen des Versorgungskreises (14) durch die Detektionsmittel (15 bis 17, 20, 21) umfasst.

13. Verfahren nach Anspruch 12, wobei der Versorgungskreis (14) zwei Widerstandsbrücken umfasst, die zwischen den Versorgungsmitteln (19) und Gleichrichtermitteln (18), wie einer Graetz-Brücke (18)angeordnet sind, **dadurch gekennzeichnet, dass** das Messen der Spannung an den Klemmen des Versorgungskreises (14) die Verstärkung durch ein Mittel (16) zur differentiellen Verstärkung der Differenz zwischen der Spannung in einer (R7, R8) der zwei Brücken (15) und der Spannung in der anderen (R9, R14) der zwei Brücken (15) umfasst.

14. Verfahren nach Anspruch 13, **dadurch gekennzeichnet, dass** das Messen der Spannung an den Klemmen des Versorgungskreises (14) den Vergleich durch ein Vergleichsmittel (17) der von dem Mittel (16) zur differentiellen Verstärkung verstärkten differentiellen Spannung mit einem Referenzwert und das Liefern einer Ausgangsspannung durch die Vergleichsmittel (17), wenn die verstärkte differentielle Spannung am Eingang größer als die Referenzspannung ist, umfasst.

15. Verfahren nach Anspruch 12, wobei der Versorgungskreis (14) Versorgungsmittel (19) und Gleichrichtermittel (18), wie eine Graetz-Brücke (18), umfasst, **dadurch gekennzeichnet, dass** das Messen der Spannung an den Klemmen des Versorgungskreises (14) den Vergleich durch ein Vergleichsmittel (24) des Spannungswertes zwischen einer der Klemmen der Versorgungsmittel (19) und einer der Klemmen der Gleichrichtermittel (18) und das Liefern einer Ausgangsspannung durch das Vergleichsmittel (24) umfasst, wenn der Unterschied zwischen der Spannung zwischen der Klemme der Versorgungsmittel (19) und der Klemme der Gleichrichtermittel (18) und der Referenzspannung positiv ist.

16. Verfahren nach Anspruch 12, wobei der Versorgungskreis (14) Versorgungsmittel (19) und Gleichrichtermittel (18), wie eine Graetz-Brücke (18), umfasst, **dadurch gekennzeichnet, dass** das Messen der Spannung an den Klemmen des Versorgungskreises (14) den Vergleich durch ein erstes Vergleichsmittel (24) des Spannungswertes zwischen einer ersten der Klemmen der Versorgungsmittel (19) und einer ersten der Klemmen der Gleichrichtermittel (18), den Vergleich durch ein zweites Vergleichsmittel (25) des Spannungswertes zwischen einer zweiten der Klemmen der Versorgungsmittel (19) und einer zweiten der Klemmen der Gleichrichtermittel (18) und das Liefern einer jeweiligen Ausgangsspannung durch das erste und zweite Vergleichsmittel (24, 25) umfasst, wenn der Unterschied zwischen der Spannung zwischen der ersten bzw. zweiten Klemme der Versorgungsmittel (19) und der ersten bzw. zweiten Klemme der Gleichrichtermittel (18) und der Referenzspannung positiv ist.

17. Verfahren nach Anspruch 16, **dadurch gekennzeichnet, dass** das Messen der Spannung an den Klemmen des Versorgungskreises (14) das Liefern einer Ausgangsspannung durch ein logisches Gatter (26) mit zwei Eingängen, die jeweils an die Ausgangsspannungen der zwei Vergleichsmittel (24, 25) angeschlossen sind, wenn mindestens eines der zwei Vergleichsmittel (24, 25) eine Ausgangsspannung liefert, umfasst.

18. Verfahren nach Anspruch 17, wobei der überwachte elektrische Schaltkreis (2 bis 7) ein Versorgungsschaltkreis eines elektronischen Gerätes ist, **dadurch gekennzeichnet, dass** es das Versetzen des elektronischen Gerätes in den Schlafmodus abhängig von dem Nichtvorhandensein einer Ausgangsspannung des logischen Gatters (26) umfasst.

## Claims

1. Monitoring device for verifying the state of an electrical circuit (2 to 7) supplied with electric power by an electric power source (1), such as an electrical circuit (2 to 7) for protecting against power surges of the type comprising at least one fuse (2 to 7) and provided at an output of the electric power source (1) in a power distribution network, or such as an electrical circuit (2 to 7) for supplying an electronic apparatus at the output of the electric power source (1), said monitoring device comprising measuring means (8 to 13) for measuring at least one electrical quantity, such as the electric power, associated with the electrical circuit (2 to 7) supplied by the electric power source (1), said measuring means (8 to 13) comprising at least one supply circuit (14) capable of generating an electric supply current and at least one measuring circuit, for example of the Rogowski type, capable of measuring said electrical quantity associated with said supply circuit (14), **characterised in that** the supply circuit (14) comprises detection means (15 to 17, 20, 21) capable of detecting the absence or the presence of current in the electric circuit (2 to 7) by measuring the voltage at the terminals of the supply circuit (14).

2. Device according to claim 1, **characterised in that** the supply circuit (14) comprises supply means (19) and rectifying means (18), such as a Graetz bridge (18), capable of rectifying the current delivered by the supply means (19), and **in that** the detection means (15 to 17, 20, 21) are arranged between the supply means (19) and the rectifying means (18).

3. Device according to claim 2, **characterised in that** the detection means (15 to 17) comprise two resistance bridges (15) in parallel between the supply means (19) and the rectifying means (18), and a differential amplification means (16), and **in that** the two resistance bridges (15) are connected to the differential amplification means (16) so as to permit the amplification of the difference between the voltage in one (R7, R8) of the two resistance bridges (15) and the voltage in the other (R9, R14) of the two resistance bridges (15).

4. Device according to claim 3, **characterised in that** each of the two resistance bridges (15) comprises two resistors (R7, R8, R9, R14) and is connected to one of the two inputs (dif-, dif+) of the differential amplification means (16) by a connection point (dif-, dif+) situated between said two resistors (R7, R8, R9, R14).

5. Device according to either claim 3 or claim 4, **characterised in that** the detection means (15 to 17) comprise a comparison means (17) capable of comparing an input voltage value with a reference voltage value and of delivering a voltage as output when the difference between the input voltage and the reference voltage is positive, and **in that** the output voltage of the differential amplification means (16) is connected to the input of the comparison means (17), such that the comparison means (17) delivers a voltage as output when the difference between the output voltage of the differential amplification means (16) and the reference voltage is positive.

6. Device according to claim 2, **characterised in that** the detection means (20) comprise at least one comparison means (24) capable of comparing an input voltage value with a reference voltage value and of delivering a voltage as output when the difference between the input voltage and the reference voltage is positive, and **in that** the voltage between one of the terminals of the supply means (19) and one of the terminals of the rectifying means (18) is connected to the input of the comparison means (24), such that the comparison means (24) delivers a voltage as output when the difference between the voltage between said terminal of the supply means (19) and said terminal of the rectifying means (18) and the reference voltage is positive.

7. Device according to claim 2, **characterised in that** the detection means (21) comprise at least two comparison means (24, 25) each capable of comparing an input voltage value with a reference voltage value and of delivering a voltage at the output when the difference between the input voltage and the reference voltage is positive, **in that** the voltage between a first of the terminals of the supply means (19) and a first of the terminals of the rectifying means (18) is connected to the input of a first (24) of the comparison means (24, 25), and **in that** the voltage between a second of the terminals of the supply means (19) and a second of the terminals of the rectifying means (18) is connected to the input of a second (25) of the comparison means (24, 25), such that the first and second comparison means (24, 25) each deliver a voltage as output when the difference between the voltage between the first or the second of the terminals of the supply means (19) and the first or the second of the terminals of the rectifying means (18) and the reference voltage is positive.

8. Device according to claim 7, **characterised in that** the detection means (21) comprise a logic gate (26) with two inputs connected to the output voltages of the two comparison means (24, 25), and capable of delivering an output voltage when at least one of the two comparison means (24, 25) delivers an output voltage.

9. Electric power distribution network comprising a plurality of branches (A to F) and an electric power source (1) capable of delivering as output electric power for each branch (A to F), at least one of the outputs of the electric power source (1) being equipped with an electrical circuit (2 to 7) for protecting against power surges of the type comprising at least one fuse (2 to 7),
**characterised in that** it comprises, for at least said output of the electric power source (1), a monitoring device according to any one of claims 1 to 6, so as to permit the detection of the absence of current in the electrical protection circuit (2 to 7) of said output of the electric power source (1).

10. Distribution network according to claim 9, **characterised in that** the electric power source (1) is capable of delivering as output three-phase electric power for at least one of the branches (A to F) of the distribution network

11. Electric power distribution circuit in an electronic apparatus, comprising an electrical supply circuit (2 to 7) and an electric power source (1) capable of delivering as output electric power to the electrical supply circuit (2 to 7),
**characterised in that** it comprises a monitoring device according to any one of claims 1, 2, 7 and 8, so as to permit the detection of the presence of current in the electrical supply circuit (2 to 7).

12. Method for monitoring the state of an electrical circuit (2 to 7) supplied with electric power by an electric power source (1), such as an electrical circuit (2 to 7) for protecting against power surges of the type comprising at least one fuse (2 to 7) and provided at an output of the electric power source (1) in an electric power distribution network, or such as an electrical circuit (2 to 7) for supplying an electronic apparatus at the output of the electric power source (1), by means of a monitoring device comprising measuring means (8 to 13) for measuring at least one electrical quantity, such as the electric power, associated with the electrical circuit (2 to 7), said measuring means (8 to 13) comprising at least one supply circuit (14) capable of generating an electric supply current and at least one measuring circuit, for example of the Rogowski type, capable of measuring said electrical quantity associated with said supply circuit (14),
**characterised in that** it comprises a step of detecting the absence or the presence of current in the electrical circuit (2 to 7) by measuring the voltage at the terminals of the supply circuit (14) by detection means (15 to 17, 20, 21).

13. Method according to claim 12, the supply circuit (14) comprising two resistance bridges (15) arranged between supply means (19) and rectifying means (18), such as a Graetz bridge (18), **characterised in that** the measurement of the voltage at the terminals of the supply circuit (14) comprises the amplification, by means of a differential amplification means (16), of the difference between the voltage in one (R7, R8) of the two bridges (15) and the voltage in the other (R9, R14) of the two bridges (15).

14. Method according to claim 13, **characterised in that** the measurement of the voltage at the terminals of the supply circuit (14) comprises the comparison, by a comparison means (17), of the differential voltage amplified by the differential amplification means (16) to a reference value and the provision of an output voltage by the comparison means (17) when the amplified differential voltage at the input is greater than the reference voltage.

15. Method according to claim 12, the supply circuit (14) comprising supply means (19) and rectifying means (18), such as a Graetz bridge (18), **characterised in that** the measurement of the voltage at the terminals of the supply circuit (14) comprises the comparison, by a comparison means (24), of the voltage value between one of the terminals of the supply means (19) and one of the terminals of the rectifying means (18), and the provision of an output voltage by the comparison means (24) when the difference between the voltage between said terminal of the supply means (19) and said terminal of the rectifying means (18) and the reference voltage is positive.

16. Method according to claim 12, the supply circuit (14) comprising supply means (19) and rectifying means (18), such as a Graetz bridge (18), **characterised in that** the measurement of the voltage at the terminals of the supply circuit (14) comprises the comparison, by a first comparison means (24), of the voltage value between a first of the terminals of the supply means (19) and a first of the terminals of the rectifying means (18), the comparison, by a second comparison means (25), of the voltage value between a second of the terminals of the supply means (19) and a second of the terminals of the rectifying means (18), and the provision of a respective output voltage by the first and second comparison means (24, 25) when the difference between the voltage between the first or the second of the terminals of the supply means (19) and the first or the second of the terminals of the rectifying means (18) and the reference voltage is positive.

17. Method according to claim 16, **characterised in that** the measurement of the voltage at the terminals of the supply circuit (14) comprises the provision, by a logic gate (26) with two inputs connected to the output voltages of the two comparison means (24, 25), of an output voltage when at least one of the two comparison means (24, 25) delivers an output voltage.

18. Method according to claim 17, the monitored electrical circuit (2 to 7) being a supply circuit of an electronic apparatus, **characterised in that** it comprises placing the electronic apparatus in standby mode as a function of the absence of voltage at the output of the logic gate (26).
